(19) Europäisches Patentamt
European Patent Office
Office européen des brevets

(11) **EP 4 571 628 A1**

(12) **EUROPEAN PATENT APPLICATION**
published in accordance with Art. 153(4) EPC

(43) Date of publication:
**18.06.2025 Bulletin 2025/25**

(21) Application number: **22954903.5**

(22) Date of filing: **08.08.2022**

(51) International Patent Classification (IPC):
**G06Q 50/08** (2012.01)    **G06Q 10/04** (2023.01)

(52) Cooperative Patent Classification (CPC):
**G06Q 10/04; G06Q 50/08**

(86) International application number:
**PCT/JP2022/030302**

(87) International publication number:
**WO 2024/033981 (15.02.2024 Gazette 2024/07)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Earthbrain Ltd.**
**Tokyo 106-6029 (JP)**

(72) Inventor: **HIRAYAMA, Masami**
**Tokyo 106-6029 (JP)**

(74) Representative: **v. Bezold & Partner**
**Patentanwälte - PartG mbB**
**Ridlerstraße 57**
**80339 München (DE)**

(54) **CONSTRUCTION ROAD ROUTE DESIGN DEVICE, CONSTRUCTION ROAD ROUTE DESIGN METHOD, AND PROGRAM**

(57)    The construction road route design device (1) includes: a current topography data acquirer (21) to acquire topography data indicating a current topography of a construction site; a design topography data acquirer (22) to acquire topography data indicating a design topography of a construction site; a road end acquirer (23) to acquire a plurality of two or more road ends that serves as a start point and an end point of a construction road; and a route searcher to search for a route between the plurality of road ends. The route searcher (25) selects nodes existing between the plurality of road ends, calculates, for a plurality of routes going through the selected nodes and leading to the plurality of road ends, costs based on construction soil amounts of the construction road from topography data of the current topography and the design topography, and selects a route that minimizes a calculated cost.

*FIG. 1*

**Description**

Technical Field

The present disclosure relates to a construction road route design device, a construction road route design method, and a program.

Background Art

Conventionally, a construction supervisor manually plans a route of a temporary road at a construction site in consideration of conformity with a final design surface, a boundary of a construction range, a gradient of slope, a cutting and filling amount, whether or not the road is likely to remain to the end, and the like. In Patent Literature 1, a user sets a two-dimensional soil transportation route by drawing a desired route on two-dimensional current topography data displayed on a display screen of a PC or a tablet terminal by use of an input device, such as a mouse and a touch pen, is disclosed.

Citation List

Patent Literature

Patent Literature 1: Unexamined Japanese Patent Application Publication No. 2021-149395

Summary of Invention

Technical Problem

However, when a route is manually planned, the planning currently requires a week to approximately a month as a planning man-hour, and it is difficult even for an experienced supervisor to design an optimal route. Further, even if a route is designed through various examinations, whether or not the designed route is optimal cannot be easily found.
The present disclosure has been made in consideration of the above-described circumstances, and an objective of the present disclosure is to enable whoever performs route design to design an optimal route.

Solution to Problem

In order to achieve the above-described objective, a construction road route design device according to the present disclosure includes:

a current topography data acquirer to acquire topography data indicating a current topography of a construction site;
a design topography data acquirer to acquire topography data indicating a design topography of a construction site;
a road end acquirer to acquire a plurality of two or more road ends that serves as a start point and an end point of a construction road; and
a route searcher to search for a route between the plurality of road ends,
in which the route searcher
selects a plurality of nodes existing between the plurality of road ends and calculates, for a plurality of routes that goes through the selected nodes and leads to the plurality of road ends, costs based on construction soil amounts of the construction road from topography data of the current topography and the design topography, and
selects a route that minimizes a calculated cost.

Advantageous Effects of Invention

The present disclosure enables whoever performs route design to design an optimal route.

Brief Description of Drawings

FIG. 1 is a diagram illustrating a functional configuration of a construction road route design device according to Embodiment 1 of the present disclosure;
FIG. 2 is a diagram illustrating a hardware configuration of the construction road route design device according to Embodiment 1 of the present disclosure;

FIG. 3 is a flowchart illustrating operation of road route design processing according to Embodiment 1 of the present disclosure;

FIG. 4A is a diagram illustrating a current topography of a construction site;

FIG. 4B is an IVB-IVB cross-sectional view illustrating a cross section taken along the line IVB-IVB;

FIG. 5 is a diagram illustrating a map that is generated by a map generator according to Embodiment 1 of the present disclosure;

FIG. 6 is a flowchart illustrating operation of route search processing according to Embodiment 1 of the present disclosure;

FIG. 7A is a diagram illustrating an arrangement of nodes in an x-y plane;

FIG. 7B is a diagram illustrating an arrangement of nodes in the z-axis direction;

FIG. 8A is a diagram illustrating a specific example of a route search method according to Embodiment 1 of the present disclosure;

FIG. 8B is another diagram illustrating the specific example of the route search method according to Embodiment 1 of the present disclosure;

FIG. 8C is still another diagram illustrating the specific example of the route search method according to Embodiment 1 of the present disclosure;

FIG. 8D is still another diagram illustrating the specific example of the route search method according to Embodiment 1 of the present disclosure;

FIG. 8E is still another diagram illustrating the specific example of the route search method according to Embodiment 1 of the present disclosure;

FIG. 8F is still another diagram illustrating the specific example of the route search method according to Embodiment 1 of the present disclosure;

FIG. 9A is a diagram illustrating a specific example of a branch point determination method according to Embodiment 2 of the present disclosure;

FIG. 9B is another diagram illustrating the specific example of the branch point determination method according to Embodiment 2 of the present disclosure;

FIG. 9C is still another diagram illustrating the specific example of the branch point determination method according to Embodiment 2 of the present disclosure;

FIG. 10 is a flowchart illustrating operation of additional branch point determination processing according to Embodiment 3 of the present disclosure;

FIG. 11A is a topographical map in which a route linking three road ends and a branch point is illustrated;

FIG. 11B is a topographical map in which a region including two road ends adjacent to each other and a branch point is enclosed;

FIG. 11C is a topographical map in which an additional branch point and routes are illustrated;

FIG. 12A is a topographical map in which a region including other two road ends adjacent to each other and a branch point is enclosed;

FIG. 12B is a topographical map in which an additional branch point and routes are illustrated;

FIG. 12C is a topographical map in which a region including other two road ends adjacent to each other and a branch point is enclosed;

FIG. 12D is a topographical map in which an additional branch point and routes are illustrated; and

FIG. 13 is a diagram illustrating an example in which nodes are arranged at a plurality of locations in a three-dimensional space.

Description of Embodiments

Hereinafter, a construction road route design device, a construction road route design method, and a program according to embodiments of the present disclosure are described in detail with reference to the drawings.

Embodiment 1

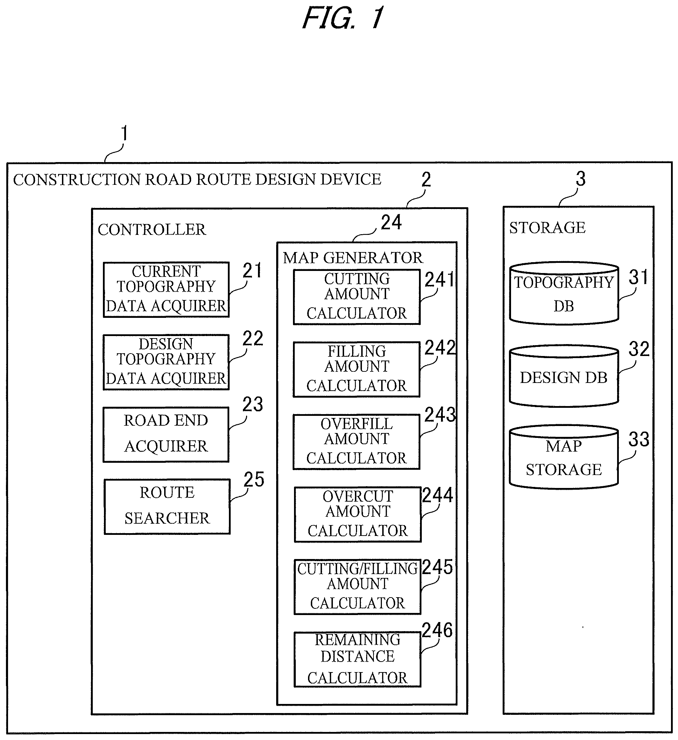

A construction road route design device 1 includes a controller 2 and a storage 3, as illustrated in FIG. 1. The controller 2 includes a current topography data acquirer 21 to acquire topography data indicating a current topography before construction at a construction site of land preparation, a design topography data acquirer 22 to acquire topography data indicating a design topography of the construction site of the land preparation, a road end acquirer 23 to acquire locations of a road start point and a road end point representing road ends that are an entrance and an exit of a construction road for a construction vehicle to travel in the construction site, respectively, a map generator 24 to generate a map of construction soil amounts, such as cutting amounts and filling amounts, required for construction from the current topography data and the design topography data, and a route searcher 25 to search for a route of a construction road.

The current topography data acquirer 21 reads two-dimensional or three-dimensional topography data that indicate a current topography before preparation of a planned preparation site from a topography database (DB) 31, which is described later, and acquires required current topography data. The current topography data are used when a route of a construction road is searched for.

The design topography data acquirer 22 reads two-dimensional or three-dimensional drawing data that indicate a final design surface of the planned preparation site from a design database (DB) 32, which is described later, and acquires required design topography data. The design topography data are used in conjunction with the current topography data when a route of a construction road is searched for.

The road end acquirer 23 acquires locations of a start point and an end point of a road that are road ends when a construction road is designed. The start point and the end point are acquired by a user inputting the start point and the end point through a keyboard, a mouse, or the like. When the start point and end point, the current topography data, and the design topography data are acquired, a search for an optimal route of a construction road is started.

The map generator 24 partitions the construction site into predetermined regions and generates a map of construction soil amounts, such as cutting amounts and filling amounts, that are required for construction of each region from the current topography data and the design topography data. The map generator 24 includes a cutting amount calculator 241 to calculate a cutting amount, a filling amount calculator 242 to calculate a filling amount, an overfill amount calculator 243 to calculate an overfill amount, an overcut amount calculator 244 to calculate an overcut amount, a cutting/filling amount calculator 245 to calculate a difference between a cutting amount and a filling amount, and a remaining distance calculator 246 to calculate remaining distance to the end point. The cutting amount calculator 241 calculates a cutting amount that is an amount of soil required to be excavated in order to, when the current topography is higher than a road surface of a construction road, make height of the topography the same as the road surface. When the cutting amount is large, the amount of excavation work increases accordingly, as a result of which a cost required for construction of the road increases. The filling amount calculator 242 calculates a filling amount that is an amount of soil required to be filled in order to, when the current topography is lower than the road surface, make height of the topography the same as the road surface. When the filling amount is large, the amount of soil filling work increases accordingly, as a result of which a cost required for construction of the road increases. The overfill amount calculator 243 calculates an overfill amount that is an amount of soil that, when the road surface of the construction road is to be formed higher than a design surface that is a final topography, is required to be filled in addition to a filling amount required to form the design surface. When the overfill amount is large, the amount of soil filling work required to form the road surface increases accordingly and excavation work to subsequently form the road surface into the final topography is further required, as a result of which a cost required for construction of the road increases. The overcut amount calculator 244 calculates an overcut amount that is an amount of soil that, when the road surface of the construction road is to be formed lower than a design surface that is a final topography, is required to be cut in addition to a cutting amount required to form the design surface. When the overcut amount is large, the amount of excavation work required to form the road surface increases accordingly and soil filling work to subsequently form the road surface into the final topography is further required, as a result of which a cost required for construction of the road increases. The cutting/filling amount calculator 245 calculates a difference between a cutting amount of a region calculated by the cutting amount calculator 241 and a filling amount of the region calculated by the filling amount calculator 242. When the difference between the cutting amount and the filling amount is large, it is accordingly required to convey excessive soil to another place or carry in lacking soil from another place, as a result of which a cost required for construction of the road increases.

The storage 3 includes the topography DB 31, the design DB 32, and a map storage 33. The topography DB 31 is a database in which current topography data are stored. The design DB 32 is a database in which design topography data are stored. The map storage 33 is a database in which a map of construction soil amounts, such as cutting amounts and filling amounts, required for construction of each region of the construction site, the map being generated by the map generator 24, is stored.

The route searcher 25 searches for an optimal route with respect to a route of a construction road from a road start point to a road end point. The route searcher 25, when searching for a route of the construction road linking the road start point and the road end point, selects a node that serves as an intermediate point that the route passes. A node is a location of an intersection point between a longitude line and a latitude line that are each lined at determined intervals (in the case of three-dimensional data, an intersection point between a longitude line and a latitude line that are each lined at determined intervals at a predetermined altitude interval), and a route is formed by tracing nodes. When nodes are selected, the route searcher 25 calculates a cost incurred between each pair of nodes based on a construction soil amount of the construction road. When costs are calculated, the route searcher 25 calculates a sum of costs from the start point to the end point and selects a route that minimizes the sum of costs as an optimal route.

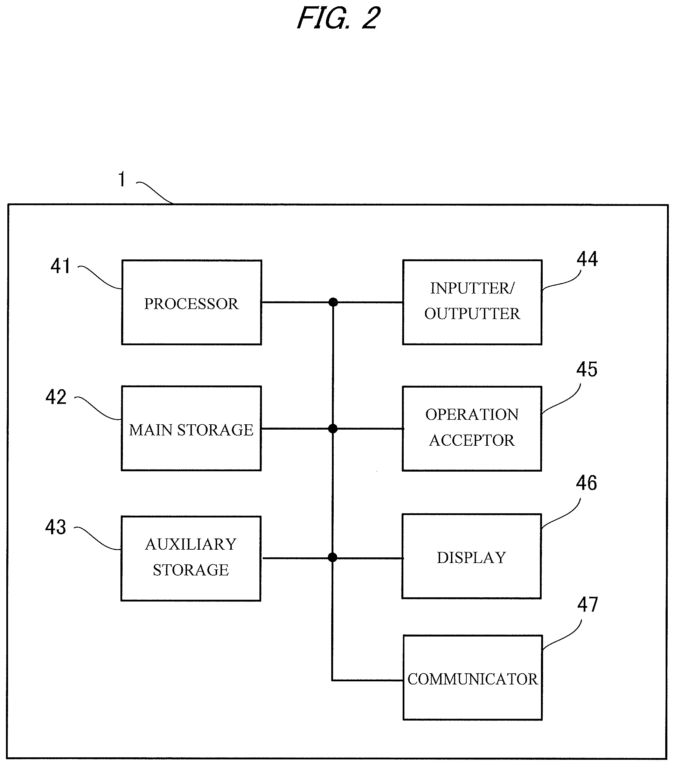

In terms of hardware configuration, the construction road route design device 1 includes a processor 41 to process data in accordance with a control program, a main storage 42 to function as a work area for the processor, an auxiliary storage 43 to store data for a long period of time, an inputter/outputter 44 to accept data input and also output data, an operation acceptor 45, a display 46, a communicator 47 to communicate with another device, and a bus to connect the foregoing elements to one another, as illustrated in FIG. 2. In the auxiliary storage 43, the control program that the processor 41 executes is stored. The operation acceptor 45 is a device for inputting various instructions to the controller 2 and includes a keyboard, an operation button, and the like. The display 46 displays a screen for execution results from various types of processing, an operation screen, and the like. The processor 41, by reading and executing programs stored in the auxiliary storage 43 in the main storage 42, functions as the current topography data acquirer 21, the design topography data acquirer 22, the road end acquirer 23, the map generator 24, and the route searcher 25, which are illustrated in FIG. 1. In addition, the auxiliary storage 43 functions as the topography DB 31, the design DB 32, and the map storage 33.

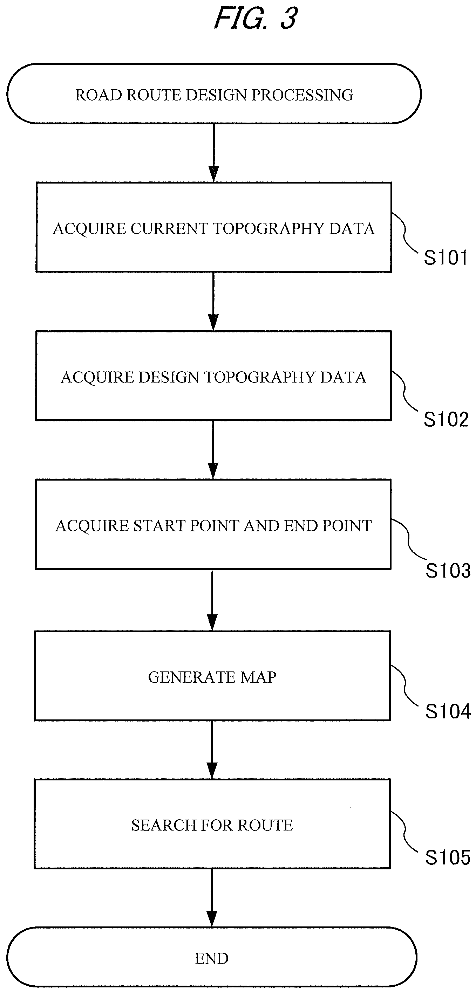

FIG. 3 is a flowchart illustrating road route design processing. As illustrated in FIG. 3, in step S101, the current topography data acquirer 21 in the controller 2 acquires current topography data of a site for which a construction road is to be designed by accessing the topography DB 31 in the storage 3. Next, in step S102, the design topography data acquirer 22 in the controller 2 acquires final design surface data of the site by accessing the design DB 32 in the storage 3. Next, in step S103, the road end acquirer 23 of the controller 2 acquires a start point and an end point of the construction road through input from a user. When the current topography data and the final design surface data are acquired, the map generator 24 in the controller 2 generates a map of construction soil amounts, such as cutting amounts and filling amounts, required for construction from the acquired current topography data and final design surface data (step S104).

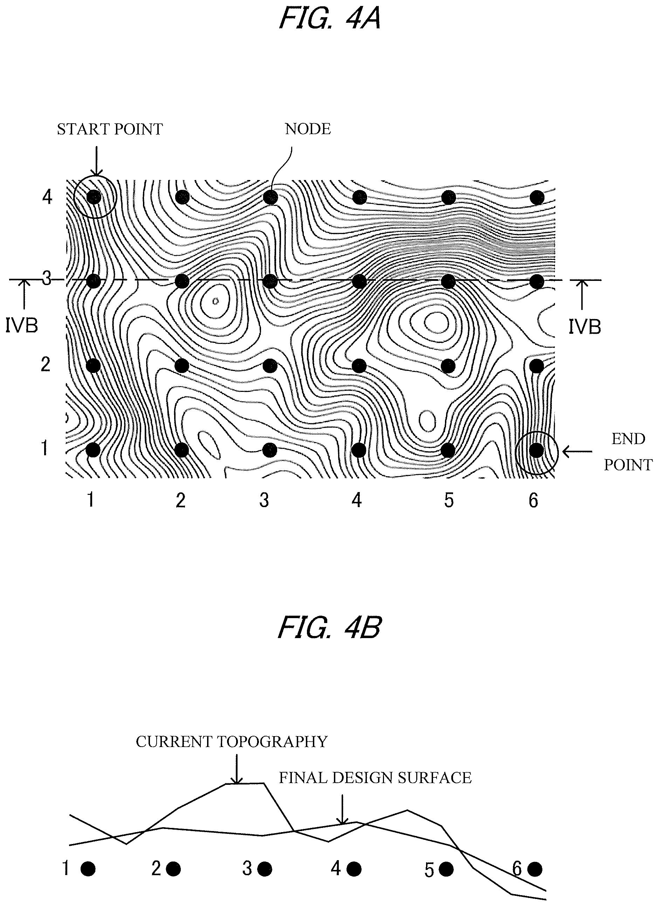

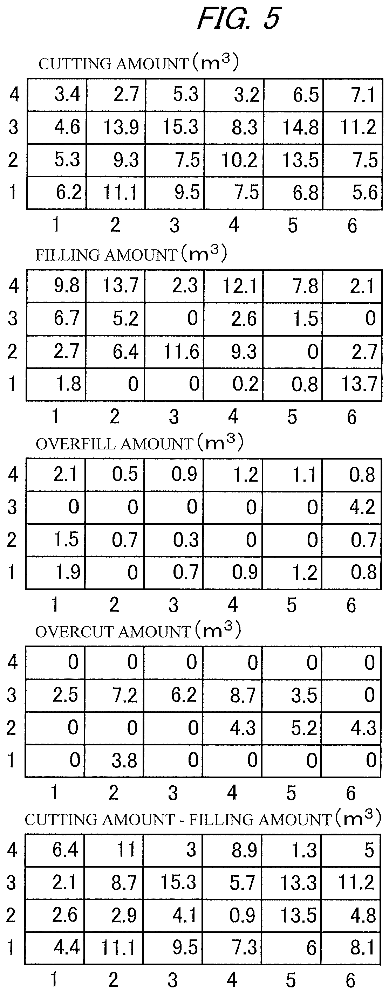

Generation of a map is described below. The current topography data and the final design surface data are superimposed on each other, and the topography data incorporate a two-dimensional or three-dimensional grid thereinto. When the grid is incorporated, soil amount data in cutting and filling soil in the case where a road is constructed between adjacent grid points are calculated. Specifically, data about each of the cutting amount, the filling amount, the overcut amount, the overfill amount, and the cutting/filling amount difference are calculated. FIGS. 4A and 4B illustrate a case where a two-dimensional grid that excludes the height dimension is incorporated. FIG. 4A illustrates a current topography of a construction site. In FIG. 4A, nodes are illustrated at positions equivalent to grid points of a square-shaped grid. The upper left end on the plane of paper in FIG. 4A is the position of the start point of a road to be set, and the lower right end indicates the end point of the road. FIG. 4B is an IVB-IVB cross-sectional view illustrating a cross section taken along the line IVB-IVB in FIG. 4A. In FIG. 4B, a cross section of the final design surface is illustrated in addition to a cross section of the current topography. In FIG. 4B, there exist not only a place at which height of the current topography is higher than the final design surface but also a place at which height of the current topography is lower than the final design surface. For a higher place, the ground at the place is required to be cut, and, for a lower place, the ground at the place is required to be filled. A map that is generated by calculating amounts of soil to be cut from and amounts of soil to be filled on the current topography, based on the final design surface is illustrated in FIG. 5. FIG. 5 illustrates each of a cutting amount, a filling amount, an overfill amount, an overcut amount, and a cutting/filling amount difference (a cutting amount - a filling amount) with respect to each of the regions including points in the construction site. The above-described map is used to calculate a cost of each route when a route is searched for. Note that generation of a map may, instead of being executed at the time of route design processing, be executed before the route design processing and stored in the storage 3 in advance.

Returning to FIG. 3, when the map is generated in step S104, the route searcher 25 in the controller 2 executes route search processing and determines an optimal route (step S105). When the optimal route is determined, the process is terminated.

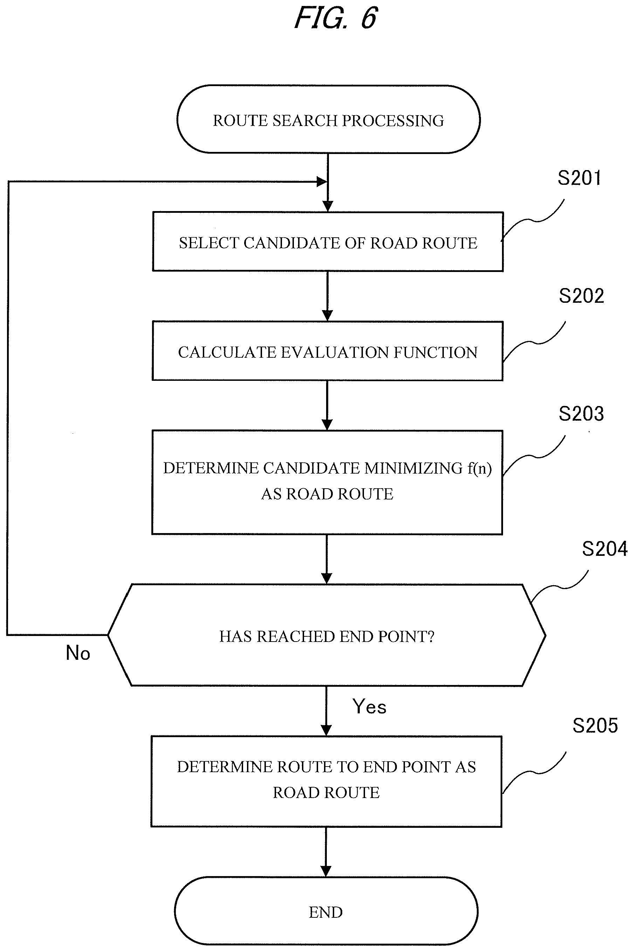

Next, the route search processing is described in detail. FIG. 6 is a flowchart illustrating road route determination processing that is executed by the route searcher 25. As illustrated in FIG. 6, in step S201, the route searcher 25 selects a candidate of a route starting from the road start point and leading to the road end point, based on the topography data. The route searcher 25 first assumes each of a plurality of nodes existing within a range of a predetermined distance from the road start point as a candidate of a first point (n=1) that the road passes and selects a plurality of routes each leading to the plurality of nodes from the road start point as candidates of a route to the first point (n=1).

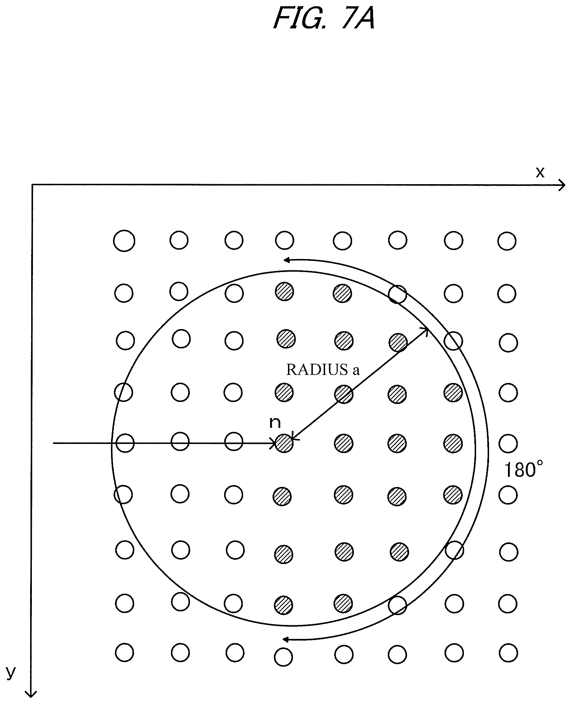

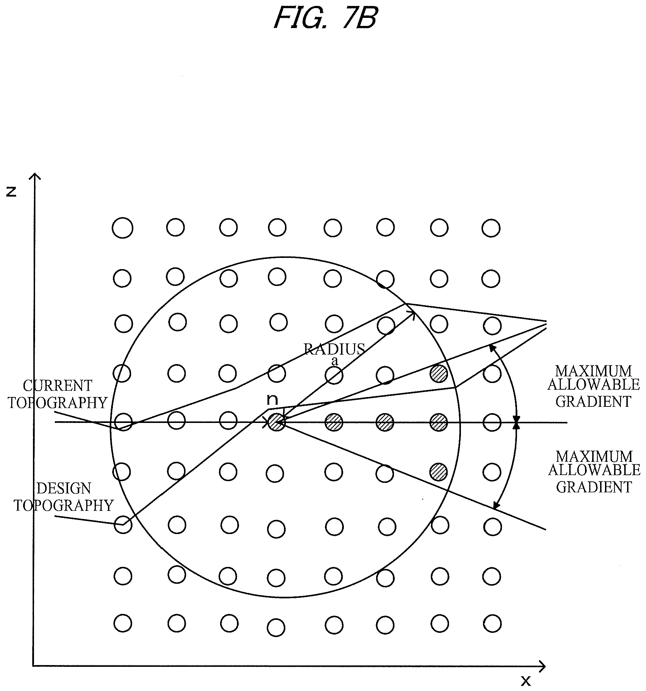

Selection of a plurality of node candidates existing within a range of a predetermined distance when route candidates are selected is described below with reference to FIGS. 7A and 7B. FIGS. 7A and 7B illustrate a plurality of nodes three-dimensionally arranged on a topographical map of a construction site, and FIGS. 7A and 7B illustrate an x-y plan view when the construction site is viewed from above and a cross-sectional view in the z-axis direction that is the altitude direction at the construction site, respectively. As illustrated in FIG. 7B, a plurality of stages of nodes that has the same longitude and latitude is defined in the height direction for each position. It is now assumed that a route to a node at the n-th point has been determined and a node candidate is to be selected in order to determine a route continuing from the node at the n-th point. In FIG. 7A, a circle with radius a is drawn around the node at the n-th point in an x-y plane. Among nodes existing within the circle with radius a, a node existing within a semicircle that is a range extending over an angle of 180 degrees on the positive side in the x-axis direction is selected as a node candidate. Shaded nodes in the drawing are node candidates satisfying the above-described condition. Further, in FIG. 7B, a circle with radius a is drawn around the node at the n-th point in the height (z-axis) direction. Among nodes existing within the circle with radius a, a node existing within a semicircle that is a range extending over an angle of 180 degrees on the positive side in the x-axis direction and existing within a range between maximum allowable gradients is selected as a node candidate. As used herein, the maximum allowable gradients are maximum gradient angles that are allowed as a gradient of a road extending from the node at the n-th point, and include both a maximum allowable gradient with respect to an ascending gradient and a maximum allowable gradient with respect to a descending gradient. Shaded nodes in the drawing are node candidates satisfying the above-described condition. That is, a node that exists within a hemisphere on the forward side in the searching direction within a sphere with a radius a around the node at the n-th point and exists within a range between the maximum allowable gradients is selected as a node candidate. With respect to the above-described selected node candidate, the route search processing from the succeeding step S202 onward is executed.

In step S202, the route searcher 25 calculates an evaluation function with respect to each of a plurality of candidates, based on soil amount data acquired from the map in FIG. 5. Note that when a plurality of nodes exists in the z-axis direction, which is the height direction, the map in FIG. 5 exists with respect to each height. The evaluation function is a cost function in an A* algorithm and is expressed by the following formula (1).

$$f(n) = g(n) + h(n) \ldots (1)$$

g(n) is a cost from the start point to the n-th point and is a soil amount function representing a cutting and filling amount. h(n) is a forecast cost from the n-th point to the end point and is a distance function representing remaining distance to the end point of the road. Since a soil amount and distance are parameters having different units, g(n) and h(n) are normalized. Normalization enables variation ranges of g(n) and h(n) in a road route evaluation process to be substantially the same. Since weights of the normalized g(n) and h(n) are substantially the same, the evaluation function f(n) can be expressed as the formula (1). The normalization causes each of the construction soil amount function g(n) and the distance function h(n) to be a dimensionless quantity. Therefore, the evaluation function f(n) is a dimensionless quantity.

Specifically, g(n) is expressed by the following formula (2).

$$g(n) = V_{(cutting\ amount)}/V_{(total\ cutting\ amount)} + V_{(filling\ amount)}/V_{(total\ filling\ amount)} + V_{(overfill\ amount)}/V_{(total\ overfill\ amount)} + V_{(overcut\ amount)}/V_{(total\ overcut\ amount)} + V_{(cutting\ and\ filling\ amount\ difference)}/V_{(total\ cutting\ and\ filling\ amount\ difference)} \quad (2)$$

$V_{(cutting\ amount)}$ is a cutting amount that is an amount of soil required to be excavated to level the ground from a current topography to a road surface at the node. $V_{(total\ cutting\ amount)}$ is a predicted value of a cutting amount that is an amount of soil required to be excavated to level the ground from a current topography to a road surface along a shortest route from the start point to the end point. $V_{(filling\ amount)}$ is a filling amount that is an amount of soil required to be filled to level the ground from the current topography to the road surface. $V_{(total\ filling\ amount)}$ is a predicted value of a filling amount that is an amount of soil required to be filled to level the ground from the current topography to the road surface along the shortest route from the start point to the end point. $V_{(overfill\ amount)}$ is an overfill amount that is an amount of soil required to be further filled on the final design surface to form a road at the n-th point. $V_{(total\ overfill\ amount)}$ is a predicted value of an overfill amount that is an amount of soil required to be further filled on the final design surface to form a road along the shortest route from the start point to the end point. $V_{(overcut\ amount)}$ is an overcut amount that is an amount of soil required to be excavated in the reverse direction to the direction from the current topography to the final design surface to form a road at the n-th point. $V_{(total\ overcut\ amount)}$ is a predicted value of an overcut amount that is an amount of soil required to be excavated in the reverse direction to the direction from the current topography to the final design surface to form a road along the shortest route from the start point to the end point. $V_{(cutting\ and\ filling\ amount\ difference)}$ is a difference between a cutting amount and a filling amount that are amounts of soil required to be excavated and filled, respectively, for leveling the ground from the current topography to the road surface. $V_{(total\ cutting\ and\ filling\ amount\ difference)}$ is a predicted value of a difference between a cutting amount and a filling amount that are amounts of soil required to be excavated and filled, respectively, for leveling the ground from the current topography to the road surface along the shortest route from the start point to the end point.

The distance function h(n) is expressed by the following formula (3).

$$h(n) = L_{(actual\ distance\ to\ end\ point)}/L_{(total\ distance)} \ldots (3)$$

$L_{(actual\ distance\ to\ end\ point)}$ is remaining distance that is a shortest distance from the n-th point to the end point. $L_{(total\ distance)}$ is a shortest distance from the road start point to the end point.

In step S203, the route searcher 25 determines a route that minimizes the evaluation function f(n) among a plurality of candidates as a road route to the n-th point.

In step S204, the route searcher 25 determines whether or not a determined node is the end point, that is, whether or not the route has reached the end point after the route determination. When a node at the end of the determined route is not the end point (step S204: No), the route searcher 25 returns to step S201 and determines a succeeding road route. When the determined node is the end point (step S204: Yes), the route searcher 25 determines the route to the determined node as a road route (step S205) and terminates the road route determination processing. That is, the route searcher 25 repeats determination of a road route until the route reaches the road end point.

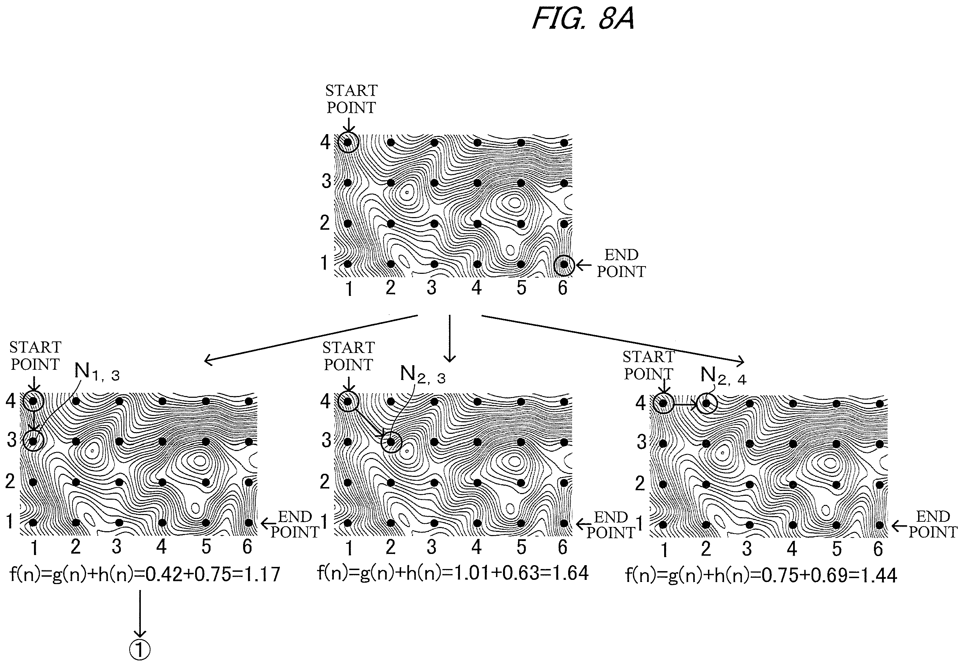

Next, a specific example of a route search method performed by the route searcher 25 is described. In the following description, for simplification of description, a case where a node candidate is selected with respect to only the x-y direction without taking into consideration the height (z-axis) direction and the radius a for selection of a candidate is assumed to be a radius causing only a node adjacent to the node at the n-th point to be included in a range with the radius is described. FIGS. 8A to 8F are diagrams illustrating a specific example of the route search method. As illustrated in FIG. 8A, since, in an initial state, determination of a route has not been started, the construction soil amount function $g(n)$ is equal to 0.

Next, the route searcher 25 selects, as a node candidate $N_{i,j}$ of a route from the start point to the first node, node candidates $N_{1,3}$, $N_{2,3}$, and $N_{2,4}$ and calculates an evaluation function $f(n)$ of each candidate. A method for determining a candidate is performed by, as described above, selecting a road route that minimizes the sum of the construction soil amount function including the cutting amount, the filling amount, the overfill amount, the overcut amount, and the cutting and filling amount difference required to construct a road and the distance function representing remaining distance to the end point. For example, at the node candidate $N_{1,3}$, the construction soil amount function $g(1)$ and $h(1)$ are calculated, based on a cutting amount, a filling amount, an overfill amount, an overcut amount, and a cutting and filling amount difference extracted with reference to FIG. 5, as $g(1) = g1(1) + g2(1) + g3(1) + g4(1) + g5(1) = 4.6/54.1 + 6.7/49.6 + 0/3.2 + 2.5/16.7 + 2.1/41.7 = 0.42$ and $h(1) = 5.4/7.2 = 0.75$, respectively. For the node candidate $N_{2,3}$, the construction soil amount function $g(1)$ and $h(1)$ are calculated as $g(1) = g1(1) + g2(1) + g3(1) + g4(1) + g5(1) = 13.9/54.1 + 5.2/49.6 + 0/3.2 + 7.2/16.7 + 8.7/41.7 = 1.01$ and $h(1) = 4.5/7.2 = 0.63$, respectively. For the node candidate $N_{2,4}$, the construction soil amount function $g(1)$ and $h(1)$ are calculated as $g(1) = g1(1) + g2(1) + g3(1) + g4(1) + g5(1) = 2.7/54.1 + 13.7/49.6 + 0.5/3.2 + 0/16.7 + 11/41.7 = 0.75$ and $h(1) = 5/7.2 = 0.69$, respectively. Therefore, with respect to the construction soil amount, the node candidate $N_{1,3}$ has the smallest value. On the other hand, with respect to the remaining distance, the node candidate $N_{2,3}$ has the smallest value. In addition, for the node candidate $N_{1,3}$, the evaluation function is calculated as $f(1) = 1.17$, for the node candidate $N_{2,3}$, the evaluation function is calculated as $f(1) = 1.64$, and, for the node candidate $N_{2,4}$, the evaluation function is calculated as $f(1) = 1.44$. Therefore, the route searcher 25 determines the route leading to the node candidate $N_{1,3}$ that minimizes the evaluation function $f(1)$ among the node candidates as a route to the first point (n=1). Since the determined node $N_{1,3}$ is not the end point, the route searcher 25 succeedingly searches for a route to the second point (n=2) that extends from the node $N_{1,3}$.

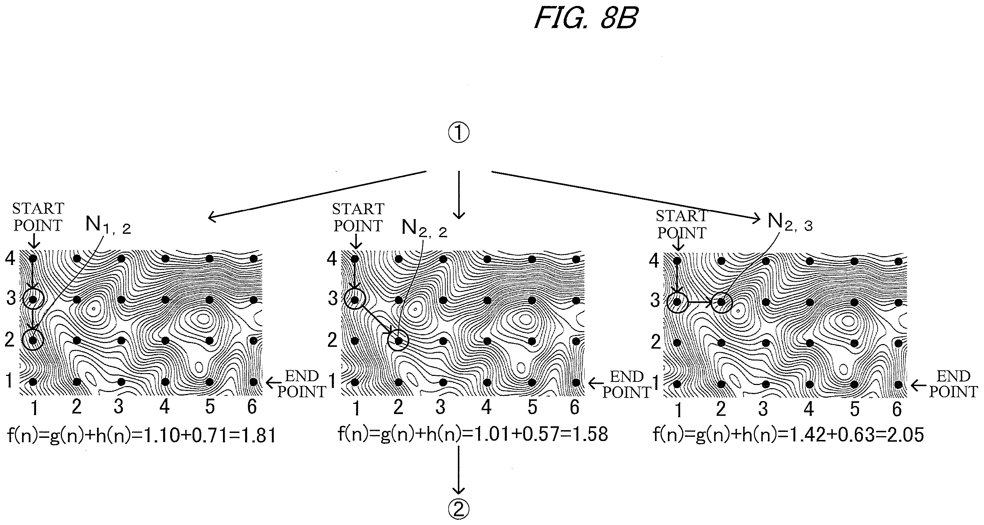

As illustrated in FIG. 8B, the route searcher 25 selects, as a node candidate of a route to the second point (n=2), node candidates $N_{1,2}$, $N_{2,2}$, and $N_{2,3}$ and calculates an evaluation function $f(n)$ of each candidate. For the node candidate $N_{1,2}$, the construction soil amount function $g(2)$ and $h(2)$ are calculated as $g(2) = g1(2) + g2(2) + g3(2) + g4(2) + g5(2) + g(1) = 5.3/54.1 + 2.7/49.6 + 1.5/3.2 + 0/16.7 + 2.6/41.7 + 0.42 = 1.1$ and $h(2) = 5.1/7.2 = 0.71$, respectively. For the node candidate $N_{2,2}$, the construction soil amount function $g(2)$ and $h(2)$ are calculated as $g(2) = g1(2) + g2(2) + g3(2) + g4(2) + g5(2) + g(1) = 9.3/54.1 + 6.4/49.6 + 0.7/3.2 + 0/16.7 + 2.9/41.7 + 0.42 = 1.01$ and $h(2) = 4.1/7.2 = 0.57$, respectively. For the node candidate $N_{2,3}$, the construction soil amount function $g(2)$ and $h(2)$ are calculated as $g(2) = g1(2) + g2(2) + g3(2) + g4(2) + g5(2) + g(1) = 13.9/54.1 + 5.2/49.6 + 0/3.2 + 7.2/16.7 + 8.7/41.7 + 0.42 = 1.42$ and $h(2) = 4.5/7.2 = 0.63$, respectively. Therefore, with respect to the construction soil amount, the node candidate $N_{2,2}$ has the smallest value. On the other hand, with respect to the remaining distance, the node candidate $N_{2,2}$ has the smallest value. In addition, for the node candidate $N_{1,2}$, the evaluation function is calculated as $f(2) = 1.81$, for the node candidate $N_{2,2}$, the evaluation function is calculated as $f(2) = 1.58$, and, for the node candidate $N_{2,3}$, the evaluation function is calculated as $f(2) = 2.05$. Therefore, the route searcher 25 determines the route leading to the node candidate $N_{2,2}$ that minimizes the evaluation function $f(2)$ among the node candidates as a route to the second point (n=2). Since the determined node $N_{2,2}$ is not the end point, the route searcher 25 succeedingly searches for a route to the third point (n=3) that extends from the node $N_{2,2}$.

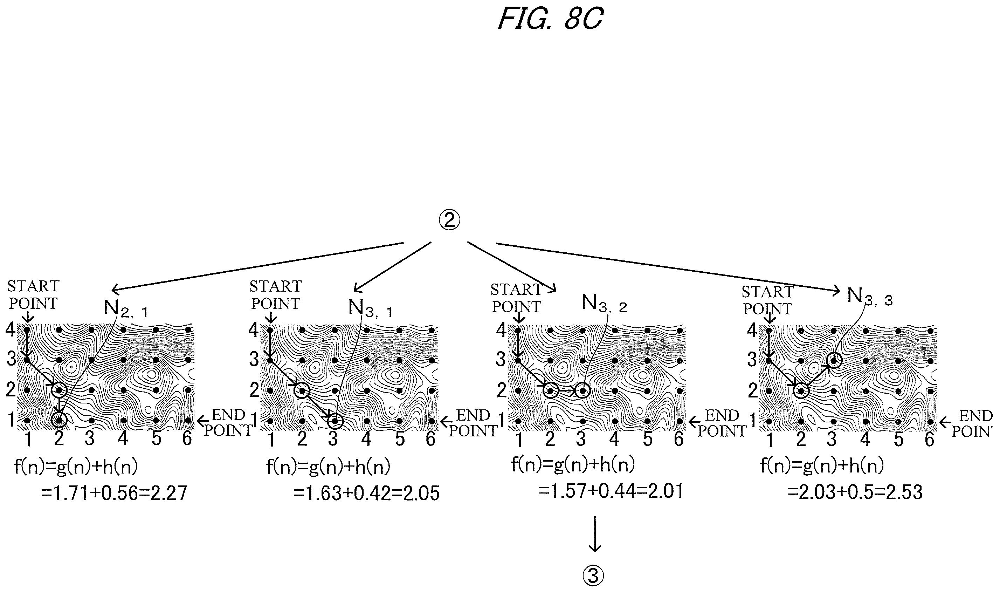

As illustrated in FIG. 8C, the route searcher 25 selects, as a candidate of a route to the third point (n=3), node candidates $N_{2,1}$, $N_{3,1}$, $N_{3,2}$, and $N_{3,3}$ and calculates an evaluation function $f(n)$ of each candidate. For the node candidate $N_{2,1}$, the construction soil amount function $g(3)$ and $h(3)$ are calculated as $g(3) = 1.71$ and $h(3) = 4/7.2 = 0.56$, respectively. For the node candidate $N_{3,1}$, the construction soil amount function $g(3)$ and $h(3)$ are calculated as $g(3) = 1.63$ and $h(3) = 3/7.2 = 0.42$, respectively. For the node candidate $N_{3,2}$, the construction soil amount function $g(3)$ and $h(3)$ are calculated as $g(3) = 1.57$ and $h(3) = 3.2/7.2 = 0.44$, respectively. In addition, for the node candidate $N_{3,3}$, the construction soil amount function $g(3)$ and $h(3)$ are calculated as $g(3) = 2.03$ and $h(3) = 3.6/7.2 = 0.5$, respectively. Therefore, with respect to the construction soil amount, the node candidate $N_{3,2}$ has the smallest value. In addition, with respect to the remaining distance, the node candidate $N_{3,1}$ has the smallest value. In addition, for the node candidate $N_{2,1}$, the evaluation function is calculated as $f(3) = 2.27$, for the node candidate $N_{3,1}$, the evaluation function is calculated as $f(3) = 2.05$, for the node candidate $N_{3,2}$, the evaluation function is calculated as $f(3) = 2.01$, and, for the node candidate $N_{3,3}$, the evaluation function is calculated as $f(3) = 2.53$. Therefore, the route searcher 25 determines the route leading to the node candidate $N_{3,2}$ that minimizes the evaluation function f(3) among the node candidates as a route to the third point (n=3). Since the determined node $N_{3,2}$ is not the end point, the route searcher 25 succeedingly searches for a route to the fourth point (n=4) that extends from the node $N_{3,2}$.

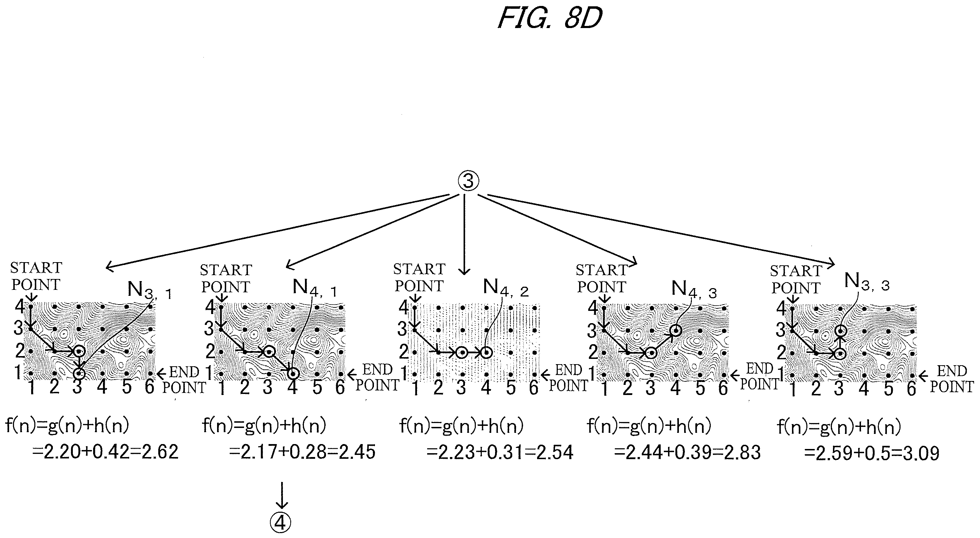

As illustrated in FIG. 8D, the route searcher 25 selects, as a candidate of a route to the fourth point (n=4), node candidates $N_{3,1}$, $N_{4,1}$, $N_{4,2}$, $N_{4,3}$, and $N_{3,3}$ and calculates an evaluation function f(n) of each candidate. For the node candidate $N_{3,1}$, the construction soil amount function g(4) and h(4) are calculated as g(4) = 2.20 and h(4) = 3/7.2 = 0.42, respectively. For the node candidate $N_{4,1}$, the construction soil amount function g(4) and h(4) are calculated as g(4) = 2.17 and h(4) = 2/7.2 = 0.28, respectively. For the node candidate $N_{4,2}$, the construction soil amount function g(4) and h(4) are calculated as g(4) = 2.23 and h(4) = 2.2/7.2 = 0.31, respectively. For the node candidate $N_{4,3}$, the construction soil amount function g(4) and h(4) are calculated as g(4) = 2.44 and h(4) = 2.8/7.2 = 0.39, respectively. For the node candidate $N_{3,3}$, the construction soil amount function g(4) and h(4) are calculated as g(4) = 2.59 and h(4) = 3.6/7.2 = 0.5, respectively. Therefore, with respect to the construction soil amount, the node candidate $N_{4,1}$ has the smallest value. In addition, with respect to the remaining distance, the node candidate $N_{4,1}$ also has the smallest value. In addition, for the node candidate $N_{3,1}$, the evaluation function is calculated as f(4) = 2.62, for the node candidate $N_{4,1}$, the evaluation function is calculated as f(4) = 2.45, for the node candidate $N_{4,2}$, the evaluation function is calculated as f(4) = 2.54, for the node candidate $N_{4,3}$, the evaluation function is calculated as f(4) = 2.83, and, for the node candidate $N_{3,3}$, the evaluation function is calculated as f(4) = 3.09. Therefore, the route searcher 25 determines the route leading to the node candidate $N_{4,1}$ that minimizes the evaluation function f(4) among the node candidates as a route to the fourth point (n=4). Since the determined node $N_{4,1}$ is not the end point, the route searcher 25 succeedingly searches for a route to the fifth point (n=5) that extends from the node $N_{4,1}$.

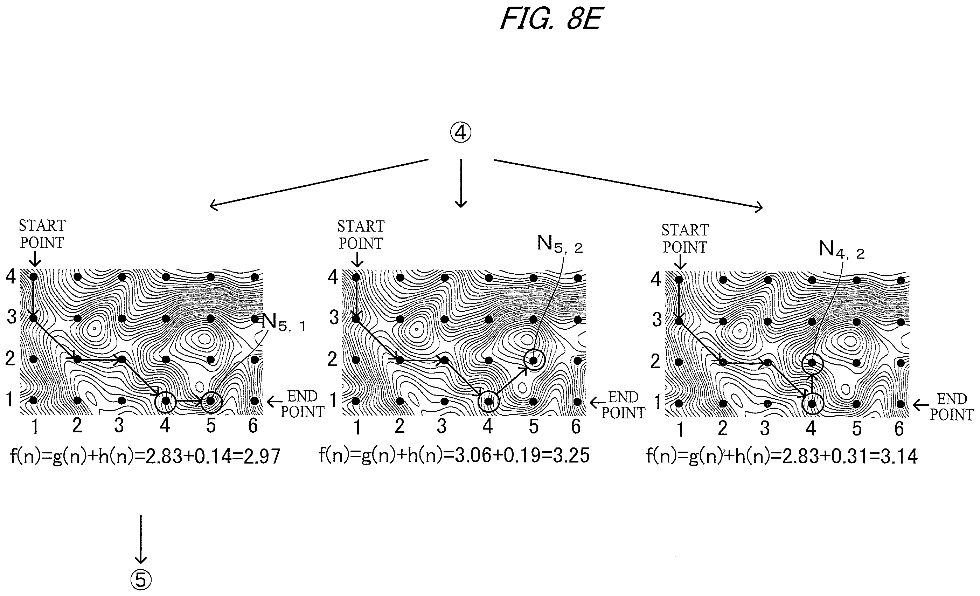

As illustrated in FIG. 8E, the route searcher 25 selects, as a candidate of a route to the fifth point (n=5), node candidates $N_{5,1}$, $N_{5,2}$, and $N_{4,2}$ and calculates an evaluation function f(n) of each candidate. For the node candidate $N_{5,1}$, the construction soil amount function g(5) and h(5) are calculated as g(5) = 2.83 and h(5) = 1/7.2 = 0.14, respectively. For the node candidate $N_{5,2}$, the construction soil amount function g(5) and h(5) are calculated as g(5) = 3.06 and h(5) = 1.4/7.2 = 0.19, respectively. For the node candidate $N_{4,2}$, the construction soil amount function g(5) and h(5) are calculated as g(5) = 2.83 and h(5) = 2.2/7.2 = 0.31, respectively. Therefore, with respect to the construction soil amount, the node candidate $N_{5,1}$ and the node candidate $N_{4,2}$ have the smallest value. In addition, with respect to the remaining distance, the node candidate $N_{5,1}$ has the smallest value. In addition, for the node candidate $N_{5,1}$, the evaluation function is calculated as f(5) = 2.97, for the node candidate $N_{5,2}$, the evaluation function is calculated as f(5) = 3.25, and, for the node candidate $N_{4,2}$, the evaluation function is calculated as f(5) = 3.14. Therefore, the route searcher 25 determines the route leading to the node candidate $N_{5,1}$ that minimizes the evaluation function f(5) among the node candidates as a route to the fifth point (n=5). Since the determined node $N_{5,1}$ is not the end point, the route searcher 25 succeedingly searches for a route to the sixth point (n=6) that extends from the node $N_{5,1}$.

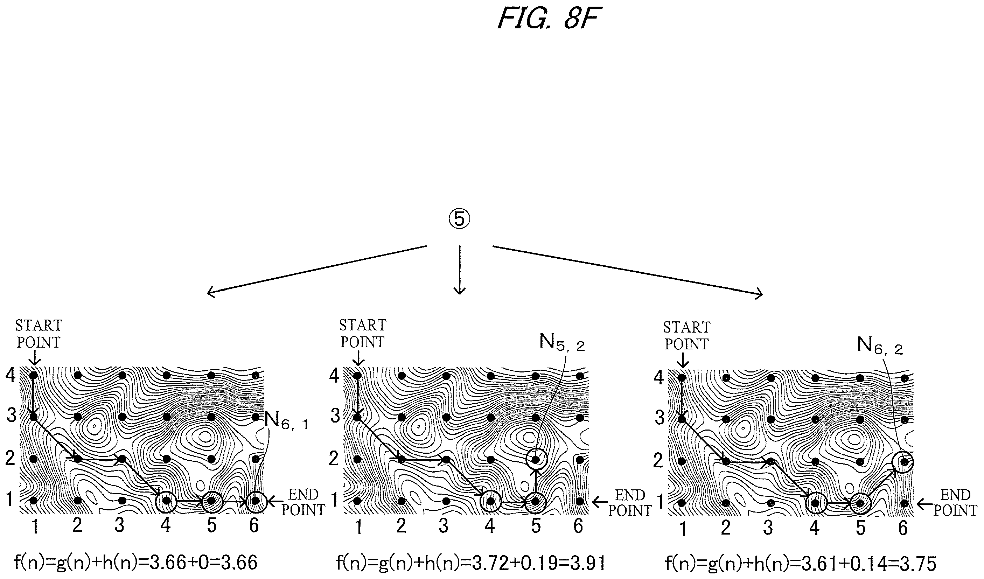

As illustrated in FIG. 8F, the route searcher 25 selects, as a candidate of a route to the sixth point (n=6), node candidates $N_{6,1}$, $N_{5,2}$, and $N_{6,2}$ and calculates an evaluation function f(n) of each candidate. For the node candidate $N_{6,1}$, the construction soil amount function g(6) and h(6) are calculated as g(6) = 3.66 and h(6) = 0/7.2 = 0, respectively. For the node candidate $N_{5,2}$, the construction soil amount function g(6) and h(6) are calculated as g(6) = 3.72 and h(6) = 1.4/7.2 = 0.19, respectively. For the node candidate $N_{6,2}$, the construction soil amount function g(6) and h(6) are calculated as g(5) = 3.61 and h(6) = 1/7.2 = 0.14, respectively. Therefore, with respect to the construction soil amount, the node candidate $N_{6,2}$ has the smallest value. In addition, with respect to the remaining distance, the node candidate $N_{6,1}$ has the smallest value. In addition, for the node candidate $N_{6,1}$, the evaluation function is calculated as f(6) = 3.66, for the node candidate $N_{5,2}$, the evaluation function is calculated as f(6) = 3.91, and, for the node candidate $N_{6,2}$, the evaluation function is calculated as f(6) = 3.75. Therefore, the route searcher 25 determines the route leading to the node candidate $N_{6,1}$ that minimizes the evaluation function f(6) among the node candidates as a route to the sixth point (n=6). Since the selected node $N_{6,1}$ is the same as the end point, the selected route reaches the end point and the route from the start point to the end point is determined.

As described above, the route searcher 25 determines a route that starts from the start point, passes the nodes $N_{1,3}$, $N_{2,2}$, $N_{3,2}$, $N_{4,1}$, and $N_{5,1}$, and reaches the node $N_{6,1}$ that is the end point as an optimal route of the construction road. Note that, in a process of determining a route, trace back may be performed.

As described in the foregoing, according to the construction road route design device according to the present embodiment, a candidate that minimizes the evaluation function f(n) among a plurality of candidates of a road route is determined as a road route by the route searcher 25. Therefore, it is not required to manually plan a route and it can be configured such that whoever plans a route can plan an optimal route

The evaluation function f(n) includes the construction soil amount function g(n) that represents a construction soil amount required to construct a road and the distance function h(n) that represents remaining distance to the end point. Therefore, it is possible to determine a shortest road route with a small construction soil amount. In addition, the cutting amount, the filling amount, the overfill amount, the overcut amount, and the cutting and filling amount difference are used as parameters representing the construction soil amount, and a route of a road that is achieved in such a manner that the foregoing items are balanced is automatically derived.

Embodiment 2

In the above-described embodiment, a case where a road has two ends, namely a road start point and a road end point, was described. In contrast, with respect to a case where three or more ends of a road exist, that is, a case where a branch point exists on a road, a method for determining a most appropriate branch point is described.

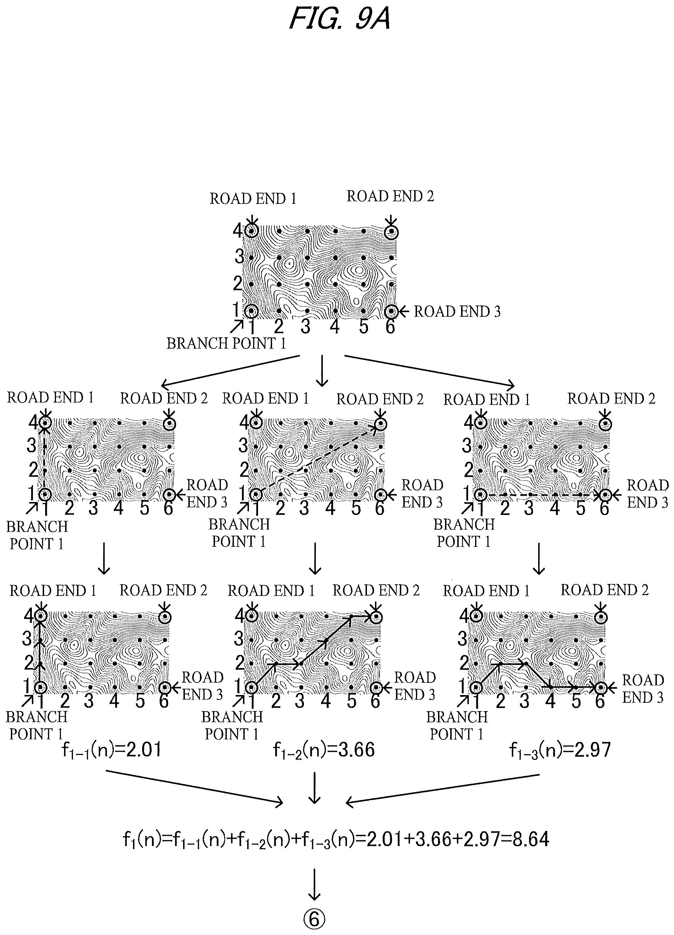

Next, a specific example of a branch point determination method performed by a route searcher 25 is described. FIGS. 9A to 9C are diagrams illustrating a specific example of the branch point determination method. In the example, an example in which a road has three ends and one branch point is to be set is described. As illustrated in FIG. 9A, a road end 1, a road end 2, and a road end 3 are set at three corners of a construction region as site road ends. When road ends are set, a search algorithm that searches for a route to each road end, using a node that is one of points of a grid in the construction region as a branch point candidate is executed and an optimal route is thereby calculated. The search algorithm makes use of an evaluation function f(n) that was used in the embodiment described afore. Since, in an initial state in which a search for a route is started from each branch point candidate, determination of a route has not been started, a construction soil amount function g(n) is equal to 0.

First, the route searcher 25 selects a branch point 1 as a first branch point candidate and calculates, with respect to an optimal route from the branch point 1 to the road end 1, a road route that minimizes the evaluation function f(n). In addition, the route searcher 25 also calculates, with respect to each of an optimal route from the branch point 1 to the road end 2 and an optimal route from the branch point 1 to the road end 3, a road route that minimizes the evaluation function f(n). In FIG. 9A, routes from the determined branch point 1 to the road end 1, the road end 2, and the road end 3 and calculated values of the evaluation function f(n) are illustrated. A cost from the branch point 1 to the road end 1 is calculated as $f_{1-1}(n) = 2.01$, a cost from the branch point 1 to the road end 2 is calculated as $f_{1-2}(n) = 3.66$, and a cost from the branch point 1 to the road end 3 is calculated as $f_{1-3}(n) = 2.97$. Therefore, a cost $f_1(n)$ of a road route linking the road ends 1, 2, and 3 in the case where the branch point 1 is set as a branch point is calculated as $f_1(n) = f_{1-1}(n) + f_{1-2}(n) + f_{1-3}(n) = 2.01 + 3.66 + 2.97 = 8.64$.

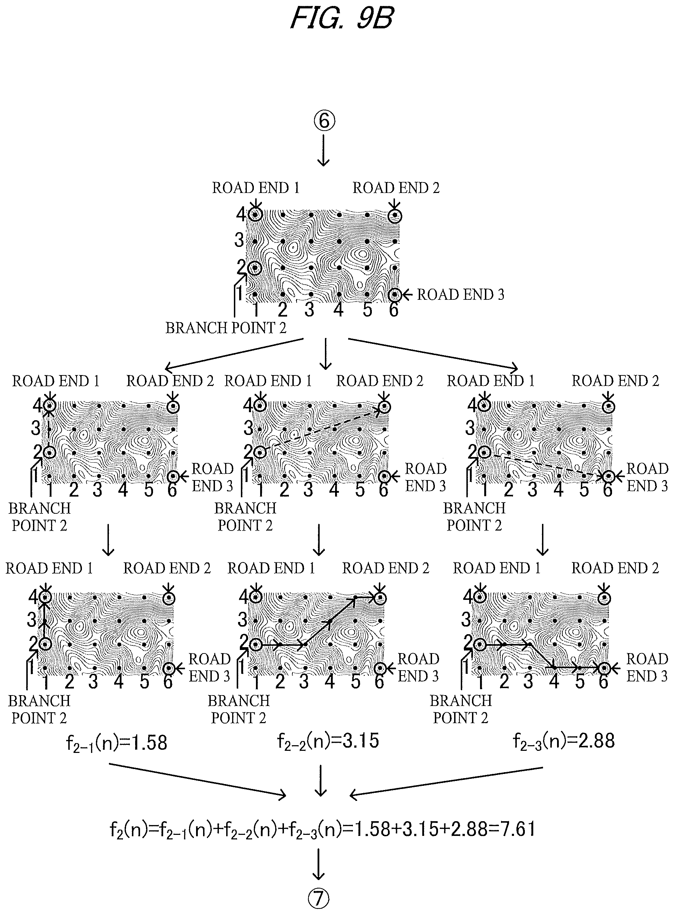

Succeedingly, the route searcher 25 selects a branch point 2 as a second branch point candidate and calculates, with respect to each of optimal routes from the branch point 2 to the road ends 1, 2, and 3, a road route that minimizes the evaluation function f(n). In FIG. 9B, routes from the determined branch point 2 to the road end 1, the road end 2, and the road end 3 and calculated values of the evaluation function f(n) are illustrated. A cost from the branch point 2 to the road end 1 is calculated as $f_{2-1}(n) = 1.58$, a cost from the branch point 2 to the road end 2 is calculated as $f_{2-2}(n) = 3.15$, and a cost from the branch point 2 to the road end 3 is calculated as $f_{2-3}(n) = 2.88$. Therefore, a cost $f_2(n)$ of a road route linking the road ends 1, 2, and 3 in the case where the branch point 2 is set as a branch point is calculated as $f_2(n) = f_{2-1}(n) + f_{2-2}(n) + f_{2-3}(n) = 1.58 + 3.15 + 2.88 = 7.61$.

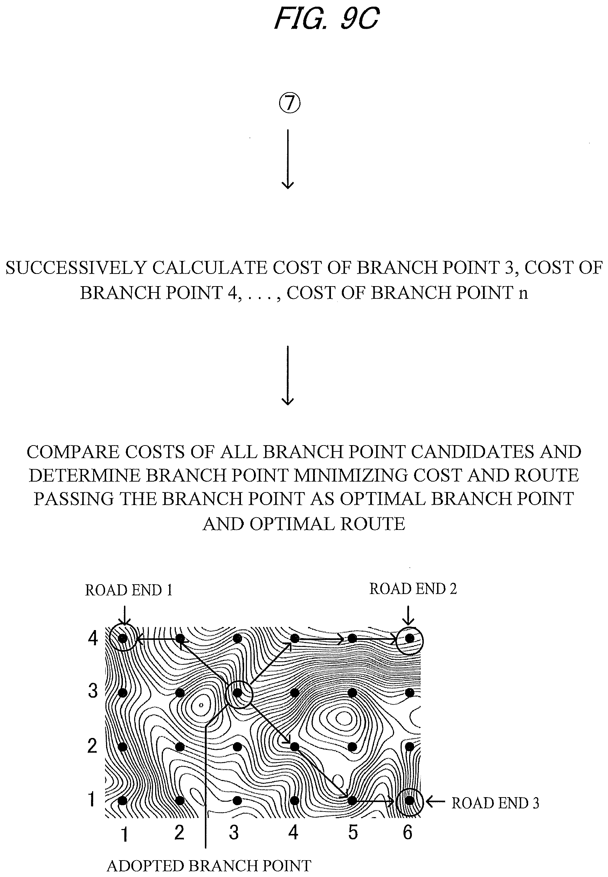

Next, as illustrated in FIG. 9C, the remaining nodes are set as branch points 3 to n and optimal routes linking the road ends 1, 2, and 3, and costs are successively calculated with respect to the branch points 3 to n in the same manner as described above.

When optimal routes and costs are calculated with respect to up to branch point n, the calculated costs $f_1(n)$ to $f_n(n)$ with respect to the branch points 1 to n are compared and a branch point that minimizes the cost is adopted as an optimal branch point. Since a route that passes the optimal branch point and links the road ends 1, 2, and 3 has already been calculated, the route is adopted as an optimal route.

Although, in the above-described example, road ends are assumed to be located at three sites, without being limited thereto, a road may have four or more road ends. In this case, calculation of an optimal branch point and a route that passes the optimal branch point is the same as the above-described calculation except that an amount of calculation of an optimal route from a branch point candidate to each road end increases according to the increased number of road ends.

Embodiment 3

In the above-described embodiment, a case where the number of branch points is one was described. In contrast, in the present embodiment, with respect to a case where, by further adding a branch point, a plurality of branch points are set, determination of optimal locations of the branch points and a route that passes a plurality of optimal branch points is described.

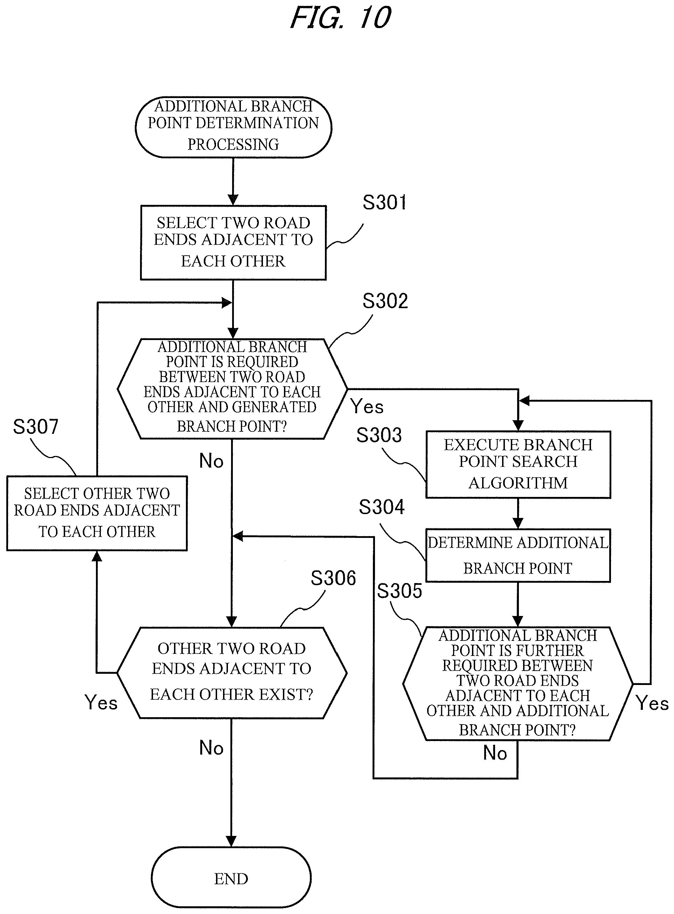

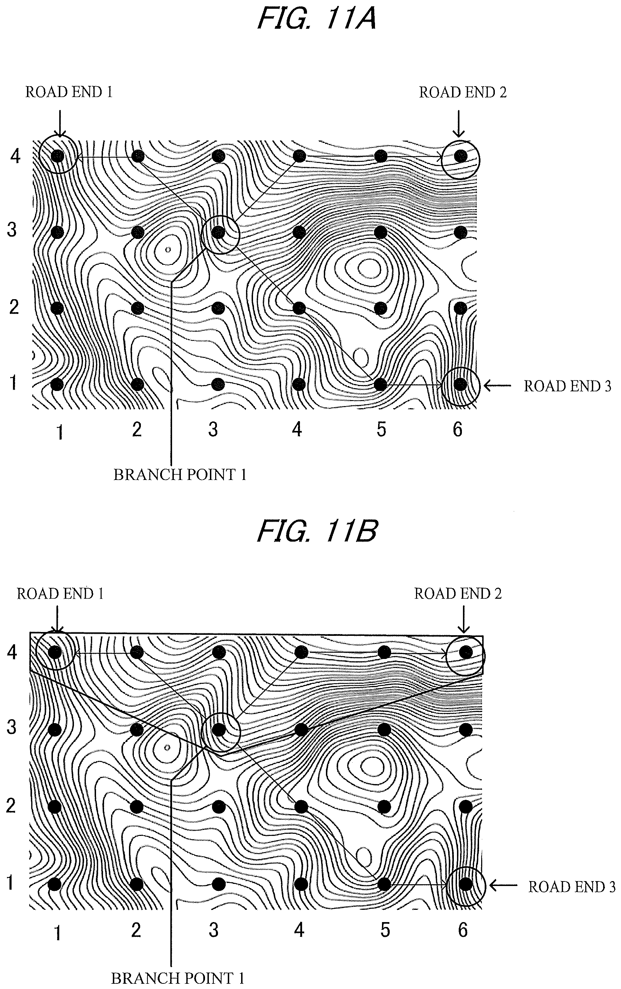

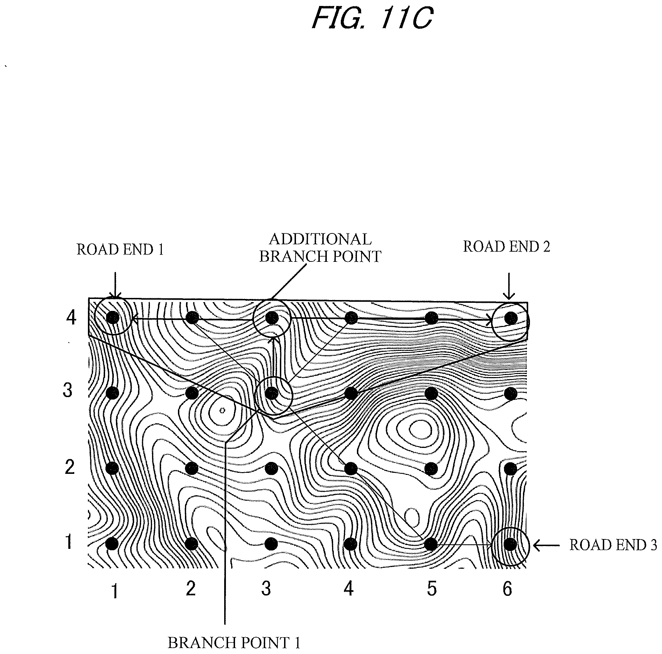

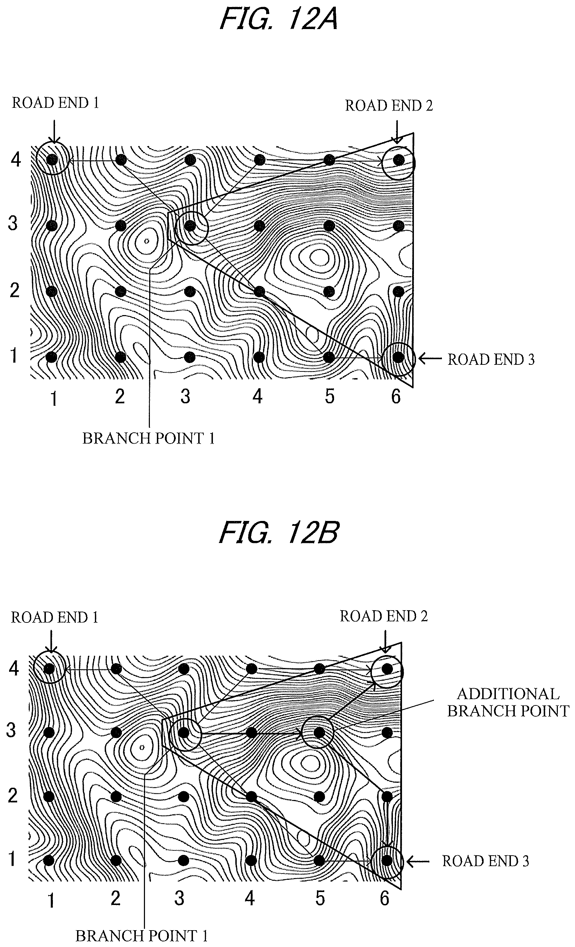

FIG. 10 illustrates determination processing of an additional branch point. A route searcher 25 selects two road ends adjacent to each other (step S301). The route searcher 25 determines whether or not an additional branch point is required to be set in a region surrounded by the selected two road ends adjacent to each other and a generated branch point (step S302). In FIGS. 11A to 11C and 12A to 12D, an example in which additional branch point determination processing is performed with respect to a case where three road ends, namely a road end 1, a road end 2, and a road end 3, are set and a branch point 1 has already been set as a branch point is described as an example. FIG. 11A illustrates a topographical map in which a route including the three road ends and the branch point 1 is indicated, and the road end 1 and the road end 2, the road end 2 and the road end 3, and the road end 3 and the road end 1 are each adjacent to each other. It is assumed that, in step S301, the road end 1 and the road end 2 are selected. The route searcher 25 encloses a region surrounded by the road end 1, the road end 2, and the generated branch point 1 by a line as illustrated in FIG. 11B and displays the topographical map illustrated in FIG. 11B on the display 46, as well as displaying intention to instruct a user to select whether it is required or not to provide an additional branch point in the region enclosed by the line. By the user, upon receiving the instruction, operating the operation acceptor 45 and thereby inputting whether or not provision of an additional branch point is required, the route searcher 25 performs determination in step S302. When it is required to provide an additional branch point (step S302: Yes), the route searcher 25 searches for an additional branch point by executing the above-described search algorithm for a branch point (step S303). In the example in FIG. 11B, the route searcher 25, using each node existing in the region enclosed by the line as a branch point candidate, calculates an optimal route to the road end 1 and a cost, an optimal route to the road end 2 and a cost, and an optimal route to the branch point 1 and a cost and, by summing the costs, calculates a cost of each additional branch point candidate. The costs of the additional branch point candidates are compared with one another, and a branch point candidate that minimizes the cost is determined as an additional branch point (step S304). In FIG. 11C, a determined additional branch point and routes from the additional branch point are illustrated. When the additional branch point is determined, the route searcher 25, by displaying whether or not another additional branch point is further required on the display 46, inquires of the user about the requirement, and, by the user, upon receiving the inquiry, inputting whether or not another additional branch point is further required through the operation acceptor 45, the route searcher 25 determines whether or not another additional branch point is further required (step S305). When the route searcher 25 determines that another additional branch point is further required (step S305: Yes), the route searcher 25 returns to step S303 and a search for an additional branch point is executed. When the route searcher 25 determines that another additional branch point is not required (step S305: No), the route searcher 25 transitions to step S306. When, in step S302, the route searcher 25 determines that an additional branch point is not required (step S302: No), the route searcher 25 also likewise transitions to step S306.

In step S306, the route searcher 25 determines whether or not other two road ends adjacent to each other exist. While, in the example in FIG. 10, determination of whether or not an additional branch point is required is performed with respect to the road end 1 and the road end 2 as two road ends adjacent to each other in the previous step, a combination of the road end 2 and the road end 3 and a combination of the road end 3 and the road end 1 exist as other two road ends adjacent to each other. Accordingly, the route searcher 25 determines that other two road ends adjacent to each other exist (step S306: Yes) and selects, for example, the road end 2 and the road end 3 as other two road ends adjacent to each other (step S307). When other two road ends adjacent to each other are selected, the route searcher 25 returns to step S302 and determines whether or not an additional branch point is required in an area surrounded by the new two road ends and the branch point. The route searcher 25 encloses a region surrounded by the road end 2, the road end 3, and the branch point 1 by a line as illustrated in FIG. 12A, displays the enclosed region on the display 46, inquires of the user about whether or not an additional branch point is required in the region enclosed by the line, and performs the determination in step S302. When it is required to provide an additional branch point (step S302: Yes), the route searcher 25 searches for an additional branch point (step S303), and, as illustrated in FIG. 12B, a determined additional branch point and routes from the additional branch point are indicated (step S304). When the additional branch point is determined, the route searcher 25 determines whether or not another additional branch point is further required (step S305) and, when determining that another additional branch point is further required (step S305: Yes), returns to step S303 and executes a search for an additional branch point and, when determining that another additional branch point is not required (step S305: No), transitions to step S306. When, in step S302, the route searcher 25 determines that an additional branch point is not required in the region enclosed by the line (step S302: No), the route searcher 25 also likewise transitions to step S306.

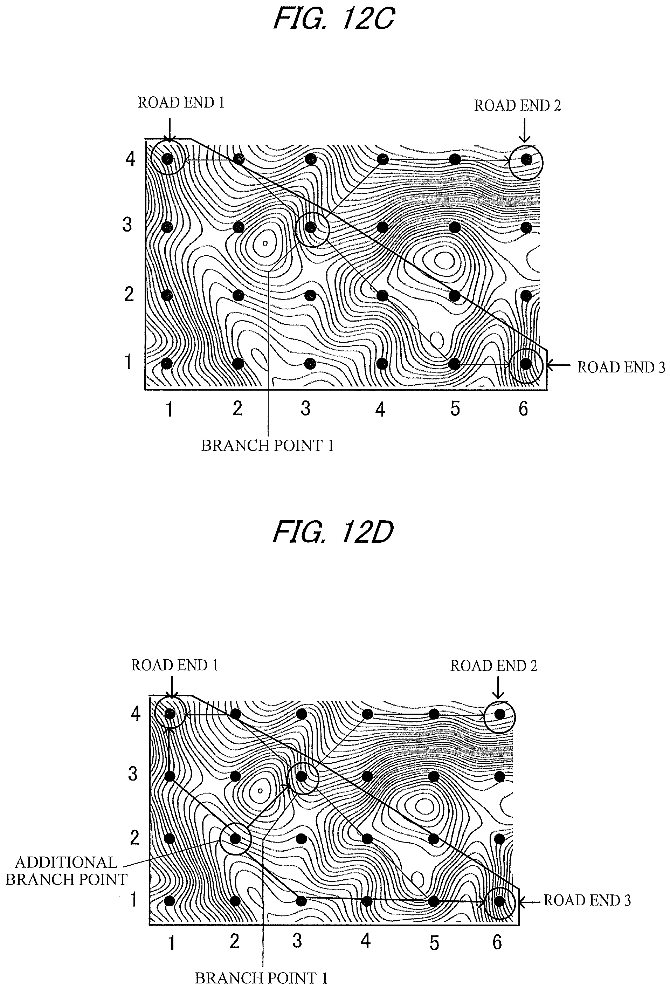

Since, in the example in FIGS. 12A and 12B, a combination of the road end 3 and the road end 1 exists as other two road ends adjacent to each other, the route searcher 25 determines that other two road ends adjacent to each other exist (step S306: Yes), selects the road end 2 and the road end 3 (step S307), and returns to step S302 and determines whether or not an additional branch point is required in a region surrounded by the new two road ends and the branch point. The route searcher 25 encloses a region surrounded by the road end 2, the road end 3, and the branch point 1 by a line as illustrated in FIG. 12C, displays the enclosed region on the display 46, inquires of the user about whether or not an additional branch point is required in the region enclosed by the line, and performs the determination in step S302. When it is required to provide an additional branch point (step S302: Yes), the route searcher 25 searches for an additional branch point (step S303), and, as illustrated in FIG. 12D, a determined additional branch point and routes from the additional branch point are indicated (step S304). When the additional branch point is determined, the route searcher 25 determines whether or not another additional branch point is further required (step S305) and, when determining that another additional branch point is further required (step S305: Yes), returns to step S303 and executes a search for an additional branch point and, when determining that another additional branch point is not required (step S305: No), transitions to step S306. When, in step S302, the route searcher 25 determines that an additional branch point is not required in the region enclosed by the line (step S302: No), the route searcher 25 also likewise transitions to step S306.

When, in step S306, no other two road ends adjacent to each other exist (step S306: No), the route searcher 25 terminates the processing. Since, in the example in FIGS. 11A to 11C and 12A to 12D, no other two road ends adjacent to each other exist, the processing is terminated.

In the above-described embodiment, it is possible to determine optimal positions with respect to a plurality of branch points. Therefore, it is possible to design an optimal route according to a demand of a user.

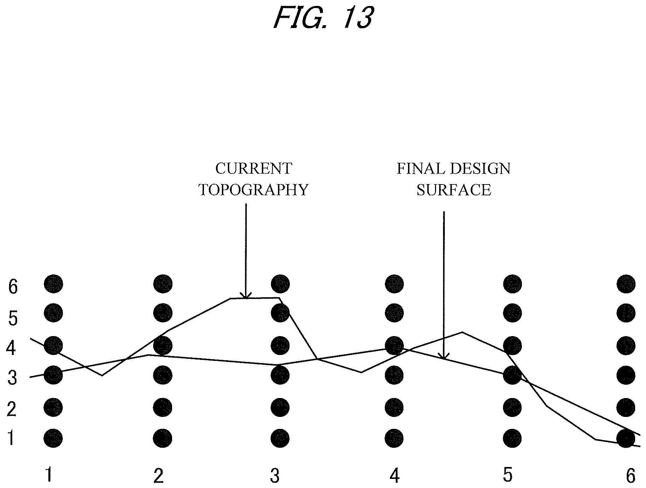

In the above-described embodiments, nodes were set in a two-dimensional space. That is, only one node was defined with respect to positions that have the same longitude and latitude. In contrast, it may be configured such that nodes are defined at a plurality of locations in a three-dimensional space. For example, as an arrangement example of nodes, a plurality of stages of nodes can be defined in the height direction, as illustrated in FIG. 13. Because of this configuration, it is possible to search for an optimal route with the height direction also taken into consideration.

Although, in the above-described embodiments, the cutting amount, the filling amount, the overfill amount, the overcut amount, the cutting and filling amount difference, and route length were used as items for cost calculation, an item other than the above-described items can be added. For example, items, such as a gradient of slope, a boundary condition of a constructible range, and a rate at which a road remains to the end, may be added. In addition, the above-described items may be selectively added according to a site at which construction is performed. In addition, items including the items used in the above-described embodiments may be replaced with other items as needed, and an item may be deleted. In addition, since a degree of influence of an item on a cost sometimes differs depending on an item and there is a possibility that a user desires to place a high value on a specific item, it may be configured such that each item is multiplied by an importance factor.

In addition, the functions of the construction road route design device 1 can be achieved by dedicated hardware or a general computer system.

For example, a device that executes the above-described processing can be configured by storing and distributing programs executed by the processor 41 in a non-transitory computer-readable recording medium and installing the programs in a computer. As such a recording medium, for example, a flexible disk, a compact disc read-only memory (CD-ROM), a digital versatile disc (DVD), or a magneto-optical disc (MO) is conceivable.

In addition, programs may be stored in advance in a disk device included in a server device on a communication network, which is represented by the Internet, and, by being superimposed on, for example, a carrier wave, be downloaded into a computer.

In addition, it is also possible to achieve the above-described processing by activating and executing programs while transferring the programs via a communication network.

Further, it is also possible to achieve the above-described processing by causing all or a portion of a program to be executed in a server device and executing the program while transmitting and receiving information relating to the processing of the program via a communication network.

Note that, when the above-described functions are achieved by the operating system (OS) sharing some of the functions, are achieved by collaboration between the OS and applications, or the like, only programs other than the OS may be stored in the above-described recording medium and distributed or may be downloaded to a computer.

In addition, means for achieving the functions of the construction road route design device 1 is not limited to software, and some or all of the functions may be achieved by dedicated hardware including a circuit.

The foregoing describes some example embodiments for explanatory purposes. Although the foregoing discussion has presented specific embodiments, persons skilled in the art will recognize that changes may be made in form and detail without departing from the broader spirit and scope of the invention. Accordingly, the specification and drawings are to be regarded in an illustrative rather than a restrictive sense. This detailed description, therefore, is not to be taken in a limiting sense, and the scope of the invention is defined only by the included claims, along with the full range of equivalents to which such claims are entitled.

Industrial Applicability

The present disclosure is applicable to a wide variety of road route design devices that design a route of a road.

Reference Signs List

1     Construction road route design device

2     Controller
3     Storage
21    Current topography data acquirer
22    Design topography data acquirer

| 23 | Road end acquirer |
|----|----|
| 24 | Map generator |
| 25 | Route searcher |
| 31 | Topography DB |
| 32 | Design DB |
| 33 | Map storage |
| 41 | Processor |
| 42 | Main storage |
| 43 | Auxiliary storage |
| 44 | Inputter/outputter |
| 45 | Operation acceptor |
| 46 | Display |
| 47 | Communicator |
| 241 | Cutting amount calculator |
| 242 | Filling amount calculator |
| 243 | Overfill amount calculator |
| 244 | Overcut amount calculator |
| 245 | Cutting/filling amount calculator |
| 246 | Remaining distance calculator |

**Claims**

1. A construction road route design device comprising:

    a current topography data acquirer to acquire topography data indicating a current topography of a construction site;
    a design topography data acquirer to acquire topography data indicating a design topography of a construction site;
    a road end acquirer to acquire a plurality of two or more road ends that serves as a start point and an end point of a construction road; and
    a route searcher to search for a route between the plurality of road ends,
    wherein the route searcher
    selects nodes existing between the plurality of road ends and calculates, for a plurality of routes that goes through the selected nodes and leads to the plurality of road ends, costs based on construction soil amounts of the construction road from topography data of the current topography and the design topography, and
    selects a route that minimizes a calculated cost.

2. The construction road route design device according to claim 1, wherein

    the route searcher
    calculates, for each of a link between each of the plurality of road ends and a node adjacent to each other and a link between each pair of nodes adjacent to each other in each route, a cost based on construction soil amount of the construction road, and
    selects a route that minimizes a sum of calculated costs.

3. The construction road route design device according to claim 1, wherein

    the route searcher
    calculates, for each of a link between each of the plurality of road ends and a node adjacent to each other and a link between each pair of nodes adjacent to each other in each route, a cost based on construction soil amount of the construction road and a cost based on remaining distance to the end point, and
    selects a route that minimizes a sum of calculated costs based on construction soil amount of the construction road and calculated costs based on remaining distance to the end point.

4. The construction road route design device according to any one of claims 1 to 3, wherein the construction soil amount includes a cutting amount and a filling amount.

5. The construction road route design device according to claim 4, wherein the construction soil amount further includes an overfill amount and an overcut amount.

6. The construction road route design device according to claim 4, wherein the construction soil amount further includes a difference between the cutting amount and the filling amount.

7. The construction road route design device according to claim 1, wherein

when the road end acquirer acquires three or more road ends as the plurality of road ends,
the route searcher
calculates, for each branch point leading to each of the plurality of road ends, a cost based on construction soil amount of the construction road between the branch point and each of the plurality of road ends, and
selects the branch point that minimizes a sum of calculated costs and a route that passes the branch point.

8. The construction road route design device according to claim 7, wherein

the route searcher,
when determining that an additional branch point is required,
calculates, with respect to each region including two road ends adjacent to each other among the plurality of road ends and the branch point, costs based on construction soil amount of the construction road between the additional branch point and each of the two road ends adjacent to each other and between the additional branch point and the branch point, and
selects the additional branch point that minimizes a sum of calculated costs and a route that passes the additional branch point.

9. A construction road route design method comprising:

acquiring topography data indicating a current topography of a construction site;
acquiring topography data indicating a design topography of a construction site;
acquiring a plurality of two or more road ends that serves as a start point and an end point of a construction road; and
selecting nodes existing between the plurality of road ends, calculating, for a plurality of routes that goes through the selected nodes and leads to the plurality of road ends, costs based on construction soil amounts of the construction road from topography data of the current topography and the design topography, and, by selecting a route that minimizes a calculated cost, searching for a route between the plurality of road ends.

10. A program causing a computer to:

acquire topography data indicating a current topography of a construction site;
acquire topography data indicating a design topography of a construction site;
acquire a plurality of two or more road ends that serves as a start point and an end point of a construction road; and
select nodes existing between the plurality of road ends, calculate, for a plurality of routes that goes through the selected nodes and leads to the plurality of road ends, costs based on construction soil amounts of the construction road from topography data of the current topography and the design topography, and, by selecting a route that minimizes a calculated cost, search for a route between the plurality of road ends.

*FIG. 1*

CONSTRUCTION ROAD ROUTE DESIGN DEVICE — 1

2 — CONTROLLER

24 — MAP GENERATOR

CURRENT TOPOGRAPHY DATA ACQUIRER — 21

DESIGN TOPOGRAPHY DATA ACQUIRER — 22

ROAD END ACQUIRER — 23

ROUTE SEARCHER — 25

CUTTING AMOUNT CALCULATOR — 241

FILLING AMOUNT CALCULATOR — 242

OVERFILL AMOUNT CALCULATOR — 243

OVERCUT AMOUNT CALCULATOR — 244

CUTTING/FILLING AMOUNT CALCULATOR — 245

REMAINING DISTANCE CALCULATOR — 246

STORAGE — 3

TOPOGRAPHY DB — 31

DESIGN DB — 32

MAP STORAGE — 33

## FIG. 2

## FIG. 3

```
┌─────────────────────────────────────┐
│   ROAD ROUTE DESIGN PROCESSING       │
└─────────────────────────────────────┘
                  │
                  ▼
┌─────────────────────────────────────┐
│  ACQUIRE CURRENT TOPOGRAPHY DATA     │  S101
└─────────────────────────────────────┘
                  │
                  ▼
┌─────────────────────────────────────┐
│  ACQUIRE DESIGN TOPOGRAPHY DATA      │  S102
└─────────────────────────────────────┘
                  │
                  ▼
┌─────────────────────────────────────┐
│  ACQUIRE START POINT AND END POINT   │  S103
└─────────────────────────────────────┘
                  │
                  ▼
┌─────────────────────────────────────┐
│           GENERATE MAP               │  S104
└─────────────────────────────────────┘
                  │
                  ▼
┌─────────────────────────────────────┐
│         SEARCH FOR ROUTE             │  S105
└─────────────────────────────────────┘
                  │
                  ▼
┌─────────────────────────────────────┐
│               END                    │
└─────────────────────────────────────┘
```

## FIG. 4A

START POINT           NODE

IVB

IVB

END POINT

## FIG. 4B

CURRENT TOPOGRAPHY

FINAL DESIGN SURFACE

## FIG. 5

CUTTING AMOUNT $(m^3)$

| | 1 | 2 | 3 | 4 | 5 | 6 |
|---|---|---|---|---|---|---|
| 4 | 3.4 | 2.7 | 5.3 | 3.2 | 6.5 | 7.1 |
| 3 | 4.6 | 13.9 | 15.3 | 8.3 | 14.8 | 11.2 |
| 2 | 5.3 | 9.3 | 7.5 | 10.2 | 13.5 | 7.5 |
| 1 | 6.2 | 11.1 | 9.5 | 7.5 | 6.8 | 5.6 |

FILLING AMOUNT $(m^3)$

| | 1 | 2 | 3 | 4 | 5 | 6 |
|---|---|---|---|---|---|---|
| 4 | 9.8 | 13.7 | 2.3 | 12.1 | 7.8 | 2.1 |
| 3 | 6.7 | 5.2 | 0 | 2.6 | 1.5 | 0 |
| 2 | 2.7 | 6.4 | 11.6 | 9.3 | 0 | 2.7 |
| 1 | 1.8 | 0 | 0 | 0.2 | 0.8 | 13.7 |

OVERFILL AMOUNT $(m^3)$

| | 1 | 2 | 3 | 4 | 5 | 6 |
|---|---|---|---|---|---|---|
| 4 | 2.1 | 0.5 | 0.9 | 1.2 | 1.1 | 0.8 |
| 3 | 0 | 0 | 0 | 0 | 0 | 4.2 |
| 2 | 1.5 | 0.7 | 0.3 | 0 | 0 | 0.7 |
| 1 | 1.9 | 0 | 0.7 | 0.9 | 1.2 | 0.8 |

OVERCUT AMOUNT $(m^3)$

| | 1 | 2 | 3 | 4 | 5 | 6 |
|---|---|---|---|---|---|---|
| 4 | 0 | 0 | 0 | 0 | 0 | 0 |
| 3 | 2.5 | 7.2 | 6.2 | 8.7 | 3.5 | 0 |
| 2 | 0 | 0 | 0 | 4.3 | 5.2 | 4.3 |
| 1 | 0 | 3.8 | 0 | 0 | 0 | 0 |

CUTTING AMOUNT - FILLING AMOUNT $(m^3)$

| | 1 | 2 | 3 | 4 | 5 | 6 |
|---|---|---|---|---|---|---|
| 4 | 6.4 | 11 | 3 | 8.9 | 1.3 | 5 |
| 3 | 2.1 | 8.7 | 15.3 | 5.7 | 13.3 | 11.2 |
| 2 | 2.6 | 2.9 | 4.1 | 0.9 | 13.5 | 4.8 |
| 1 | 4.4 | 11.1 | 9.5 | 7.3 | 6 | 8.1 |

## FIG. 6

```
        ┌─────────────────────────────┐
        │   ROUTE SEARCH PROCESSING   │
        └─────────────────────────────┘
                      │
                      ▼
        ┌─────────────────────────────┐   S201
        │  SELECT CANDIDATE OF ROAD ROUTE │
        └─────────────────────────────┘
                      │
                      ▼
        ┌─────────────────────────────┐   S202
        │ CALCULATE EVALUATION FUNCTION │
        └─────────────────────────────┘
                      │
                      ▼
        ┌─────────────────────────────┐   S203
        │ DETERMINE CANDIDATE MINIMIZING f(n) │
        │        AS ROAD ROUTE        │
        └─────────────────────────────┘
                      │
                      ▼
   No  ╱─────────────────────────────╲   S204
  ◄────┤      HAS REACHED END POINT?   │
       ╲─────────────────────────────╱
                      │ Yes
                      ▼
        ┌─────────────────────────────┐   S205
        │ DETERMINE ROUTE TO END POINT AS │
        │        ROAD ROUTE           │
        └─────────────────────────────┘
                      │
                      ▼
        ┌─────────────────────────────┐
        │             END             │
        └─────────────────────────────┘
```

# FIG. 7A

## FIG. 7B

FIG. 8A

# FIG. 8B

EP 4 571 628 A1

# FIG. 8C

② 

START POINT

$N_{2,1}$

4
3
2
1

1 2 3 4 5 6 ← END POINT

$f(n)=g(n)+h(n)$
$=1.71+0.56=2.27$

START POINT

$N_{3,1}$

4
3
2
1

1 2 3 4 5 6 ← END POINT

$f(n)=g(n)+h(n)$
$=1.63+0.42=2.05$

START POINT

$N_{3,2}$

4
3
2
1

1 2 3 4 5 6 ← END POINT

$f(n)=g(n)+h(n)$
$=1.57+0.44=2.01$

START POINT

$N_{3,3}$

4
3
2
1

1 2 3 4 5 6 ← END POINT

$f(n)=g(n)+h(n)$
$=2.03+0.5=2.53$

③

*FIG. 8D*

$f(n)=g(n)+h(n)$
$=2.20+0.42=2.62$

$f(n)=g(n)+h(n)$
$=2.17+0.28=2.45$

$f(n)=g(n)+h(n)$
$=2.23+0.31=2.54$

$f(n)=g(n)+h(n)$
$=2.44+0.39=2.83$

$f(n)=g(n)+h(n)$
$=2.59+0.5=3.09$

EP 4 571 628 A1

FIG. 8E

*FIG. 8F*

## FIG. 9A

$$f_{1-1}(n)=2.01 \qquad f_{1-2}(n)=3.66 \qquad f_{1-3}(n)=2.97$$

$$f_1(n)=f_{1-1}(n)+f_{1-2}(n)+f_{1-3}(n)=2.01+3.66+2.97=8.64$$

⑥

## FIG. 9B

⑥

ROAD END 1          ROAD END 2

BRANCH POINT 2

ROAD END 1    ROAD END 2    ROAD END 1    ROAD END 2    ROAD END 1    ROAD END 2

BRANCH          BRANCH          BRANCH
POINT 2          POINT 2          POINT 2

ROAD END 1    ROAD END 2    ROAD END 1    ROAD END 2    ROAD END 1    ROAD END 2

BRANCH          BRANCH          BRANCH
POINT 2          POINT 2          POINT 2

$f_{2-1}(n)=1.58$          $f_{2-2}(n)=3.15$          $f_{2-3}(n)=2.88$

$$f_2(n)=f_{2-1}(n)+f_{2-2}(n)+f_{2-3}(n)=1.58+3.15+2.88=7.61$$

⑦

## FIG. 9C

⑦

↓

SUCCESSIVELY CALCULATE COST OF BRANCH POINT 3, COST OF
BRANCH POINT 4, . . . , COST OF BRANCH POINT n

↓

COMPARE COSTS OF ALL BRANCH POINT CANDIDATES AND
DETERMINE BRANCH POINT MINIMIZING COST AND ROUTE
PASSING THE BRANCH POINT AS OPTIMAL BRANCH POINT
AND OPTIMAL ROUTE

ROAD END 1                    ROAD END 2

← ROAD END 3

ADOPTED BRANCH POINT

## FIG. 10

ADDITIONAL BRANCH POINT DETERMINATION PROCESSING

S301 — SELECT TWO ROAD ENDS ADJACENT TO EACH OTHER

S302 — ADDITIONAL BRANCH POINT IS REQUIRED BETWEEN TWO ROAD ENDS ADJACENT TO EACH OTHER AND GENERATED BRANCH POINT?

Yes → S303 — EXECUTE BRANCH POINT SEARCH ALGORITHM

No

S307 — SELECT OTHER TWO ROAD ENDS ADJACENT TO EACH OTHER

S304 — DETERMINE ADDITIONAL BRANCH POINT

S306 — OTHER TWO ROAD ENDS ADJACENT TO EACH OTHER EXIST?

Yes

No

S305 — ADDITIONAL BRANCH POINT IS FURTHER REQUIRED BETWEEN TWO ROAD ENDS ADJACENT TO EACH OTHER AND ADDITIONAL BRANCH POINT?

Yes

No

END

## FIG. 11A

## FIG. 11B

# FIG. 11C

## FIG. 12A

## FIG. 12B

## FIG. 12C

## FIG. 12D

## FIG. 13

CURRENT
TOPOGRAPHY

FINAL DESIGN
SURFACE

## INTERNATIONAL SEARCH REPORT

| International application No. |
| --- |
| **PCT/JP2022/030302** |

**A. CLASSIFICATION OF SUBJECT MATTER**

*G06Q 50/08*(2012.01)i; *G06Q 10/04*(2012.01)i
FI:  G06Q50/08; G06Q10/04

According to International Patent Classification (IPC) or to both national classification and IPC

**B. FIELDS SEARCHED**

Minimum documentation searched (classification system followed by classification symbols)

G06Q10/00-99/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2021-101316 A (KOMATSU MFG CO LTD) 08 July 2021 (2021-07-08) entire text, all drawings | 1-10 |
| A | JP 2021-80801 A (JAPAN DEV & CONSTRUCTION) 27 May 2021 (2021-05-27) entire text, all drawings | 1-10 |
| A | CN 111005273 A (CHINA 19TH METALLURGICAL CORPORATION) 14 April 2020 (2020-04-14) entire text, all drawings | 1-10 |
| A | JP 2021-149395 A (OKUMURA CORP) 27 September 2021 (2021-09-27) entire text, all drawings | 1-10 |

☐ Further documents are listed in the continuation of Box C.   ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **18 October 2022** | **25 October 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/030302**

| Patent document cited in search report | | | Publication date (day/month/year) | Patent family member(s) | Publication date (day/month/year) |
|---|---|---|---|---|---|
| JP | 2021-101316 | A | 08 July 2021 | WO 2021/131864 A1 entire text, all drawings | |
| JP | 2021-80801 | A | 27 May 2021 | (Family: none) | |
| CN | 111005273 | A | 14 April 2020 | (Family: none) | |
| JP | 2021-149395 | A | 27 September 2021 | (Family: none) | |

Form PCT/ISA/210 (patent family annex) (January 2015)

**EP 4 571 628 A1**

**Patent documents cited in the description**

- JP 2021149395 A